# EUROPEAN PATENT APPLICATION

(11) **EP 3 878 897 A1**
(43) Date of publication of application: **15.09.2021**
(21) Application number: 19882078.9
(22) Date of filing: 01.11.2019
(51) Int. Cl.: C08J 7/12, C08G 18/34, C08G 18/38, C08G 18/65, B24B 37/24, H01L 21/304

(54) **POLYURETHANE FOR POLISHING LAYERS, POLISHING LAYER, POLISHING PAD AND METHOD FOR MODIFYING POLISHING LAYER**

(30) Priority: 09.11.2018 JP 2018211758
(71) Applicant: Kuraray Co., Ltd., Kurashiki-shi, Okayama 710-0801 (JP)
(72) Inventor: SUNAYAMA, Azusa, Kurashiki-shi, Okayama 713-8550 (JP); KATO, Mitsuru, Kurashiki-shi, Okayama 713-8550 (JP); TAKEGOSHI, Minori, Kurashiki-shi, Okayama 713-8550 (JP); OKAMOTO, Chihiro, Kurashiki-shi, Okayama 713-8550 (JP); KATO, Shinya, Tokyo 100-8115 (JP)
(74) Representative: Vossius & Partner Patentanwälte Rechtsanwälte mbB
(86) International application number: PCT/JP2019/043003
(87) International publication number: WO 2020/095832

(57) **Abstract**

Disclosed is a polyurethane for use in a polishing layer, including a carboxylic acid ester group, and a polyurethane preferably having a carboxylic acid ester group in at least one of a side chain, a main chain terminal, and a main chain skeleton is preferably used. Also disclosed is a method for modifying a polishing layer, including the steps of: preparing a polishing layer including a polyurethane having a carboxylic acid ester group; and hydrolyzing the carboxylic acid ester group of the polyurethane, to produce a carboxyl group.

## Description

### [Technical Field]

The present invention relates to a novel polyurethane that can be suitably used as a material of a polishing layer of a polishing pad.

### [Background Art]

Chemical mechanical polishing (CMP) is known as a polishing method used, for example, for mirror-finishing a semiconductor wafer, or planarizing the surface of an object to be polished that includes an insulating film such as an oxide film or a conductive material film in a process of forming a circuit on a semiconductor substrate. CMP is a method in which an object to be polished is polished with high precision using a polishing pad, while supplying a slurry containing abrasive grains and a reaction liquid onto the surface of the object to be polished. Polyurethanes are used as materials for a polishing layer of the polishing pad used for CMP.

With the recent increase in the level of integration and the number of multilayered interconnections of circuits formed on a semiconductor substrate, there is a need for an increased polishing rate and even higher planarization performance for CMP. To meet such a need, a technique has been proposed that adjusts the surface state of a polyurethane in order to increase the polishing rate by increasing the affinity between the abrasive grains and the polishing surface. For example, PTL 1 listed below discloses a polishing pad that reduces the time required for a preparation step (break-in (start-up)) of roughening the surface of the polishing pad, the preparation step being a dressing treatment in the initial usage stage in which the polishing pad is attached to a polishing device and the polishing device is started. Specifically, PTL 1 discloses a polishing pad including a polishing surface pressed onto an object to be polished, wherein corrugations on the polishing surface have a cycle in the range of 5 mm to 200 mm, and a maximum amplitude of 40 µm or less. PTL 1 also discloses that when the zeta potential of the polishing surface of the polishing pad is -50 mV or more and less than 0 mv, repulsion against negatively charged abrasive grains contained in the slurry for the polishing surface is suppressed, and a fit between the polishing surface of the polishing pad and the abrasive grains thus becomes favorable, as a result of which the break-in time can be reduced.

PTL 2 listed below discloses a polishing pad that inhibits the adhesion of polishing debris to a polishing surface so as to reduce the occurrence of scratches and defects on the surface of an object to be polished, thus increasing the product yield and achieving high planarization performance and an adequate polishing rate. Specifically, PTL 2 discloses a polishing pad wherein a zeta potential of a polishing surface opposing the object to be polished is less than -55 mv and -100 mV or more.

PTL 3 listed below discloses a polishing pad that can perform polishing with a low load without causing defects in an insulating layer during CMP, and is fixed to a platen when used for polishing. Specifically, PTL 3 discloses a polishing pad wherein a material having a tensile modulus at room temperature of 0.2 GPa or more, and a zeta potential of +0.1 to +30 mV in a pH region of a slurry supplied between an object to be polished and the polishing surface of the polishing pad is used for at least a portion of the polishing surface of the polishing pad that comes into contact with the object to be polished. PTL 3 also discloses, as a comparative example, a polishing pad wherein the zeta potential is -8.5 mV when CMP is performed using an acidic slurry having a pH of 3 to 5.

PTL 4 listed below discloses a polishing sheet obtained by impregnating a non-woven fabric with a liquid mixture containing a carboxyl group-containing polyurethane resin (A), an ammonium salt of carboxylic acid having 1 to 4 carbon atoms (B), and water (C), followed by drying. PTL 4 discloses that the carboxyl group-containing polyurethane resin enhances the hydrophilicity of the polishing sheet.

Meanwhile, although this is not a technique relating to polishing pads, a technique for introducing a carboxylic acid ester group into a polyurethane is known. For example, PTL 5 listed below discloses a method for producing a novel, optically active polyurethane wherein an optically active tartaric acid diester or an optically active 1,2-diphenyl ethylene glycol is reacted with a diisocyanate.

### [Citation List]

### [Patent Literatures]

[PTL 1] WO 2008-029725
[PTL 2] Japanese Laid-Open Patent Publication No. 2013-018056
[PTL 3] Japanese Laid-Open Patent Publication No. 2005-294661
[PTL 4] Japanese Laid-Open Patent Publication No. 2006-36909
[PTL 5] Japanese Examined Patent Publication No. 06-099534

### [Summary of Invention]

### [Technical Problem]

An object of the present invention to provide a novel polyurethane that can be suitably used as a material of a polishing layer of a polishing pad, a polishing layer including the polyurethane, a polishing pad, and a method for modifying a polishing layer.

### [Solution to Problem]

An aspect the present invention is directed to a polyurethane for use in a polishing layer, including a carboxylic acid ester group. A carboxylic acid ester group produces a carboxylic acid by being hydrolyzed. With the use of a polyurethane having such a carboxylic acid ester group, carboxylic acid can be produced by hydrolyzing the carboxylic acid ester group after molding the polyurethane. Carboxylic acid increases the hydrophilicity of the polyurethane surface, thus enhancing the wettability thereof. In the case of using the polyurethane as the material of the polishing layer of a polishing pad, it is possible to adjust the zeta potential, which is the surface potential, of the polishing surface by selecting the hydrolysis treatment conditions to adjust the level of hydrolysis. It is also possible to introduce various functional groups into the polyurethane by changing the carboxylic acid into other functional groups. Preferably, the polyurethane has the carboxylic acid ester group in at least one of a side chain, a main chain terminal, and a main chain skeleton. When the polyurethane includes the carboxylic acid ester group in a side chain or a terminal, the molecular mobility of the carboxylic acid ester group is increased. In particular, when the carboxylic acid ester group in introduced into a side chain, it is possible to ensure a sufficient amount of the carboxylic acid ester group introduced, regardless of the length of the molecular chain of the polyurethane. Furthermore, when the polyurethane includes the carboxylic acid ester group in the main chain, the carboxylic acid ester group can be included in the polyol, so that it is possible to ensure a sufficient amount of the carboxylic acid ester group introduced, regardless of the ratio of the hard segment to the soft segment. Furthermore, when the carboxylic acid ester group is introduced in the terminal, a high ratio of modification can be ensured in a stable manner in terms of the molecular mobility, and the positions of introduction in the polymer can be easily made uniform, so that it is also possible to ensure a high ratio of modification mainly for chains having average to low molecular lengths, and keep the reactivity stable by making the positions of introduction uniform.

Examples of the polyurethane having a carboxylic acid ester group include a polyurethane including a monomer unit having a carboxylic acid ester group. Specifically, it is preferable that the polyurethane is, for example, a polyurethane including, as the monomer unit, at least a chain extender unit (a), a polymer polyol unit (b), and an organic diisocyanate unit (c), and at least one of the chain extender unit (a) and the polymer polyol unit (b) has the carboxylic acid ester group, since the carboxylic acid ester group can be easily retained by the polyurethane. Specific examples of the chain extender (a) having a carboxylic acid ester group include a tartaric acid diester, 1-(tert-butoxycarbonyl)-3-pyrrolidinol, and methyl 2,4-dihydroxybenzoate.

It is preferable that the polyurethane is a thermoplastic polyurethane, since a thermoplastic polyurethane can be continuously produced by continuous melt-polymerization, and also has excellent extrusion moldability using a T-die.

Another aspect of the present invention is directed to a polishing layer including any one of the above-described polyurethanes. The surface properties of such a polishing layer can be modified by hydrolyzing the carboxylic acid ester group after molding. It is preferable that the polishing layer is an unfoamed molded body, since it is possible to obtain a polishing layer whose polishing characteristics are less likely to vary and that can realize stable polishing.

Another aspect of the present invention is directed to a method for modifying a polishing layer, including the steps of: preparing a polishing layer including a polyurethane having a carboxylic acid ester group; and hydrolyzing the carboxylic acid ester group of the polyurethane, to produce a carboxyl group. With the use of such a method for modifying a polishing layer, it is possible to produce carboxylic acid on the surface of the polishing layer by hydrolyzing the carboxylic acid ester group after molding the polishing layer, thus modifying the surface properties. Accordingly, in the case of using such a polishing layer, it is possible to adjust the zeta potential, which is the surface potential, of the polishing surface by modifying the surface properties.

Another aspect of the present invention is directed to a polishing layer including a thermoplastic polyurethane having a carboxyl group, wherein the polishing layer has a zeta potential at a pH of 3.0 to 8.0, of -1.0 mV or less. Such a polishing layer is preferable in that it exhibits high affinity for abrasive grains not only when using an alkaline slurry, but also when using an acidic slurry.

It is preferable that the polishing layer has a contact angle with water of 80 degrees or less, since this provides both excellent polishing uniformity and excellent polishing stability.

Another aspect of the present invention is directed to a polishing pad including any one of the above-described polishing layers.

### [Advantageous Effects of Invention]

According to the present invention, it is possible to obtain a novel polyurethane that can be suitably used as a material of a polishing layer of a polishing pad. Furthermore, the surface properties of the polishing layer of the polishing pad can be easily modified after molding.

### [Brief Description of Drawings]

[FIG. 1] FIG. 1 is a schematic structural diagram of a polyurethane having a carboxylic acid ester group.
[FIG. 2] FIG. 2 is an explanatory diagram illustrating a process of modifying a polyurethane having a carboxylic acid ester group into a polyurethane retaining a carboxyl group.
[FIG. 3] FIG. 3 is an explanatory diagram illustrating the dissociation of a carboxyl group introduced into a polyurethane.
[FIG. 4] FIG. 4 is an explanatory diagram illustrating a polishing method using a polishing pad according to an embodiment.

### [Description of Embodiment]

Hereinafter, an embodiment of a polyurethane, a polishing layer, a polishing pad, and a method for modifying a polishing layer according to the present invention will be described in detail.

The polyurethane according to the present embodiment is a polyurethane having a carboxylic acid ester group. Specific examples thereof include a polyurethane having a carboxylic acid ester group in at least one of a side chain, a main chain terminal, and a main chain skeleton.

The polyurethane having a carboxylic acid ester group can be produced, for example, by a polyurethane production method using a known prepolymer method or one-shot method, using a polyurethane monomer raw material containing at least a chain extender (a), a polymer polyol (b), and an organic diisocyanate (c), wherein at least one of the chain extender (a) and the polymer polyol (b) is a compound having a carboxylic acid ester group. Specifically, examples thereof include a method in which the polyurethane monomer raw material at a predetermined ratio is subjected to continuous melt-polymerization substantially in the absence of a solvent, while being melt-mixed, using a single-screw or multi-screw extruder, a method in which the polyurethane monomer raw material is subjected to solution polymerization in the presence of a solvent, and a method in which the polyurethane monomer raw material is subjected to emulsion polymerization.

The polyurethane may be a thermoplastic polyurethane, or may be a thermosetting polyurethane. When used as a polishing layer of a polishing pad, it is preferable that the polyurethane is a thermoplastic polyurethane, in terms of the excellent extrusion moldability using a T-die. In the present embodiment, a thermoplastic polyurethane will be described in detail below as a representative example of a polyurethane having a carboxylic acid ester group.

The chain extender (a) is a low-molecular weight compound such as a diol compound or a diamine compound having, in the molecule, two or more active hydrogen atoms capable of reacting with an isocyanate group and having a molecular weight of preferably 300 or less. In order to cause the carboxylic acid ester group to be retained by the side chain of the polyurethane, it is preferable to use a chain extender (a1) having a carboxylic acid ester group as at least a part of the chain extender (a).

Specific examples of the chain extender (a1) having a carboxylic acid ester group include tartaric acid diesters such as diethyl tartrate and dimethyl tartrate; and diols or diamines containing a carboxylic acid ester group, such as methyl 2,4-dihydroxybenzoate, methyl 3,5-dihydroxy benzoate, neopentyl glycol mono(hydroxypivalate), or derivatives thereof. These may be used alone or in a combination of two or more. Among these, diethyl tartrate is particularly preferable since a polyurethane having excellent reactivity and excellent mechanical properties is easily obtained.

Examples of a chain extender (a2) having no carboxylic acid ester group, other than the chain extender (a1) having a carboxylic acid ester group, include low-molecular weight compounds that have been conventionally used for producing polyurethanes, have no carboxylic acid ester group, have, in the molecule, two or more active hydrogen atoms capable of reacting with an isocyanate group, and have a molecular weight of 300 or less. Specific examples thereof include diols such as ethylene glycol, diethylene glycol, 1,2-propane diol, 1,3-propanediol, 2,2-diethyl-1,3-propanediol, 1,2-butanediol, 1,3-butanediol, 2,3-butanediol, 1,4-butanediol, 1,5-pentanediol, neopentyl glycol, 1,6-hexanediol, 3-methyl-1,5-pentanediol, 1,4-bis(β-hydroxyethoxy)benzene, 1,4-cyclohexanediol, cyclohexane dimethanols such as 1,4-cyclohexanedimethanol, bis(β-hydroxyethyl)terephthalate, 1,9-nonanediol, m-xylylene glycol, p-xylylene glycol, diethylene glycol, and triethylene glycol; and diamines such as ethylenediamine, trimethylenediamine, tetramethylenediamine, hexamethylenediamine, heptamethylenediamine, octamethylenediamine, nonamethylenediamine, decamethylenediamine, undecamethylenediamine, dodecamethylenediamine, 2,2,4-trimethylhexamethylenediamine, 2,4,4-trimethylhexamethylenediamine, 3-methylpentamethylenediamine, 1,2-cyclohexanediamine, 1,3-cyclohexanediamine, 1,4-cyclohexanediamine, 1,2-diaminopropane, hydrazine, xylylenediamine, isophoronediamine, piperazine, o-phenylenediamine, m-phenylenediamine, p-phenylenediamine, tolylenediamine, xylenediamine, adipic acid dihydrazide, isophthalic acid dihydrazide, 4,4'-diaminodiphenylmethane, 4,4'-diaminodiphenylether, 4,4'-bis(4-aminophenoxy)biphenyl, 4,4'-bis(3-aminophenoxy)biphenyl, 1,4-bis(4-aminophenoxy)benzene, 1,3-bis(4-aminophenoxy)benzene, 1,3-bis(3-aminophenoxy)benzene, 3,4'-diaminodiphenylether, 4,4'-diaminodiphenylsulfone, 3,4-diaminodiphenylsulfone, 3,3'-diaminodiphenylsulfone, 4,4'-methylene-bis(2-chloroaniline), 3,3'-dimethyl-4,4'-diaminobiphenyl, 4,4'-diaminodiphenylsulfide, 2,6-diaminotoluene, 2,4-diaminochlorobenzene, 1,2-diaminoanthraquinone, 1,4-diaminoanthraquinone, 3,3'-diaminobenzophenone, 3,4-diaminobenzophenone, 4,4'-diaminobenzophenone, 4,4'-diaminobibenzyl, 2,2'-diamino-1,1'-binaphthalene, 1,n-bis(4-aminophenoxy)alkane (n is 3 to 10), including, for example, 1,3-bis(4-aminophenoxy)alkane, 1,4-bis(4-aminophenoxy)alkane, and 1,5-bis(4-aminophenoxy)alkane, 1,2-bis[2-(4-aminophenoxy)ethoxy]ethane, 9,9-bis(4-aminophenyl)fluorene, and 4,4'-diaminobenzanilide. These may be used alone or in a combination of two or more. Among these, 1,4-butanediol is preferable.

In order to cause the carboxylic acid ester group to be retained by the main chain terminal of the polyurethane, it is also possible to use, as the compound having a carboxylic acid ester group, a monool or monoamine having a carboxylic acid ester group, such as neopentyl glycol mono(hydroxypivalate)1-(tert-butoxycarbonyl)-3-pyrrolidinol. These may be used alone or in a combination of two or more.

When a monool or monoamine having a carboxylic acid ester group is also included in the chain extender (a1), the proportion of the chain extender (a1) in the total amount of the chain extender (a) can be selected as appropriate, but is preferably for example, 5 to 95 mol%, and more preferably 10 to 90 mol%, since the carboxylic acid ester group can be sufficiently provided to the side chain or main chain terminal of the polyurethane.

Examples of the polymer polyol (b) include polymer polyols having a number-average molecular weight exceeding 300, such as polyether polyol, polyester polyol, and polycarbonate polyol. In the case of producing a thermoplastic polyurethane, a polymer diol can be mainly used. In order to cause the carboxylic acid ester group to be retained by the polyurethane, a polymer polyol (b1) having a carboxylic acid ester group may be used.

Specific examples of the polymer polyol (b1) having a carboxylic acid ester group include a polycarbonate diol having a carboxylic acid ester group.

As a polymer polyol (b2) having no carboxylic acid ester group, other than the polymer polyol (b1) having a carboxylic acid ester group, polymer polyols that have been conventionally used for producing polyurethanes, have no carboxylic acid ester group, and have a number-average molecular weight exceeding 300, such as polyether polyol, polyester polyol, and polycarbonate polyol, can be used without any particular limitation.

Specific examples of the polymer polyol (b2) include a polyether diol, a polyester diol, and a polycarbonate diol that have no carboxylic acid ester group. These may be used alone or in a combination of two or more.

Specific examples of the polyether diol include polyethylene glycol, polypropylene glycol, polytetramethylene glycol, poly(methyltetramethylene)glycol, and glycerin-based polyalkylene ether glycol. These may be used alone or in a combination of two or more. Among these, it is preferable to use polyethylene glycol and polytetramethylene glycol, and in particular, polytetramethylene glycol is preferable.

A polyester diol can be obtained, for example, by a direct esterification reaction or a transesterification reaction between a dicarboxylic acid or an ester thereof, or an ester-forming derivative (etc., anhydride) thereof, and a low-molecular weight diol.

Specific examples of the dicarboxylic acid or an ester or ester-forming derivative (anhydride, etc.) thereof for producing the polyester diol include aliphatic dicarboxylic acids having 2 to 12 carbon atoms, such as oxalic acid, succinic acid, glutaric acid, adipic acid, pimelic acid, suberic acid, azelaic acid, sebacic acid, dodecanedicarboxylic acid, 2-methyl succinic acid, 2-methyl adipic acid, 3-methyl adipic acid, 3-methylpentanedioic acid, 2-methyloctanedioic acid, 3,8-dimethyldecanedioic acid, and 3,7-dimethyldecanedioic acid; aliphatic dicarboxylic acids such as dimerized aliphatic dicarboxylic acids (dimer acids) having 14 to 48 carbon atoms and obtained by the dimerization of unsaturated fatty acids obtained by the fractional distillation of triglycerides, as well as hydrogenated products (hydrogenated dimer acids) therefrom; alicyclic dicarboxylic acids such as 1,4-cyclohexane dicarboxylic acid; and aromatic dicarboxylic acids such as terephthalic acid, isophthalic acid, and ortho-phthalic acid. Specific examples of the dimer acid and the hydrogenated dimer acid include "Pripol 1004", "Pripol 1006", "Pripol 1009", and "Pripol 1013" (trade names, manufactured by Unichema). These may be used alone or in a combination of two or more.

Specific examples of the low-molecular weight diol for producing the polyester diol include: aliphatic diols such as ethylene glycol, 1,3-propanediol, 1,2-propanediol, 2-methyl-1,3-propanediol, 1,4-butanediol, neopentyl glycol, 1,5-pentanediol, 3-methyl-1,5-pentanediol, 1,6-hexanediol, 1,7-heptanediol, 1,8-octanediol, 2-methyl-1,8-octanediol, 1,9-nonanediol, and 1,10-decanediol; and alicyclic diols such as cyclohexanedimethanol and cyclohexanediol. These may be used alone or in a combination of two or more. Among these, diols having 6 to 12 carbon atoms are preferable, diols having 8 to 10 carbon atoms are more preferable, and diols having 9 carbon atoms are particularly preferable.

Examples of the polycarbonate diol include polycarbonate diols obtained by the reaction of a low-molecular weight diol and a carbonate compound such as dialkyl carbonate, alkylene carbonate, and diaryl carbonate. Examples of the low-molecular weight diol for producing the polycarbonate diol include the low-molecular weight diols listed above as examples. Examples of the dialkyl carbonate include dimethyl carbonate and diethyl carbonate. Examples of the alkylene carbonate include ethylene carbonate. Examples of the diaryl carbonate include diphenyl carbonate.

The number-average molecular weight of the polymer diol (b) is preferably 300 to 3000, more preferably 500 to 2700, and particularly preferably 500 to 2400, since a polyurethane suitable for a polishing layer maintaining the required properties such as the rigidity, the hardness and the hydrophilicity is easily obtained. Note that the number-average molecular weight of the polymer diol means a number-average molecular weight calculated based on the hydroxyl value measured in accordance with JIS K 1557.

The proportion of the polymer polyol (b1) in the total amount of the polymer polyol (b) in the case of using the polymer polyol (b1) having a carboxylic acid ester group can be selected as appropriate, but is, for example, preferably 10 to 100 mol%, and more preferably 20 to 90 mol%, since the carboxylic acid ester group can be sufficiently provided to the polyurethane, while maintaining the mechanical properties.

As the organic diisocyanate (c), any organic diisocyanate that has been conventionally used for producing polyurethanes can be used without any particular limitation. Specific examples thereof include aliphatic or alicyclic diisocyanates such as ethylene diisocyanate, tetramethylene diisocyanate, pentamethylene diisocyanate, hexamethylene diisocyanate, 2,2,4-trimethyl hexamethylene diisocyanate, 2,4,4-trimethyl hexamethylene diisocyanate, dodecamethylene diisocyanate, isophorone diisocyanate, isopropylidene bis(4-cyclohexyl isocyanate), cyclohexyl methane diisocyanate, methyl cyclohexane diisocyanate, 4,4'-dicyclohexyl methane diisocyanate, lysine diisocyanate, 2,6-diisocyanato methyl caproate, bis(2-isocyanatoethyl)fumarate, bis(2-isocyanato ethyl)carbonate, 2-isocyanatoethyl-2,6-diisocyanatohexanoate, cyclohexylene diisocyanate, methyl cyclohexylene diisocyanate, and bis(2-isocyanatoethyl)-4-cyclohexylene; and aromatic diisocyanates such 2,4'-diphenylmethane diisocyanate, 4,4'-diphenylmethane diisocyanate, 2,4-tolylene diisocyanate, 2,6-tolylene diisocyanate, m-phenylene diisocyanate, p-phenylene diisocyanate, m-xylylene diisocyanate, p-xylylene diisocyanate, 1,5-naphthylene diisocyanate, 4,4'-diisocyanatobiphenyl, 3,3'-dimethyl-4,4'-diisocyanatobiphenyl, 3,3'-dimethyl-4,4'-diisocyanatodiphenyl methane, chlorophenylene-2,4-diisocyanate, and tetramethyl xylylene diisocyanate. These may be used alone or in a combination of two or more. Among these, 4,4'-diphenylmethane diisocyanate is particularly preferable since a polyurethane suitable for a polishing layer with excellent abrasion resistance can be obtained.

The thermoplastic polyurethane having a carboxylic acid ester group can be obtained by a polyurethane production method utilizing a known prepolymer method or one-shot method, using a polyurethane monomer raw material containing a compound having a carboxylic acid ester group. In terms of the excellent productivity, the one-shot method is preferably used in which continuous melt-polymerization is performed, preferably, substantially in the absence of a solvent, using a single-screw or multi-screw extruder, while melt-mixing the above-described components blended at a predetermined ratio.

The blending proportions of the various components are appropriately adjusted according to the intended characteristics. For example, the components are preferably blended at such proportions that the isocyanate group contained in the organic polyisocyanate (c) is preferably 0.95 to 1.3 moles, more preferably 0.96 to 1.10 moles, and particularly preferably 0.97 to 1.05 moles, per mole of the active hydrogen atoms contained in the chain extender (a) and the polymer polyol (b).

The thermoplastic polyurethane having a carboxylic acid ester group, obtained by performing continuous melt-polymerization in the above-described manner, is, for example, pelletized and subsequently molded into a sheet-shaped molded body by any of various molding methods such as extrusion molding, injection molding, blow molding, and calendering. In particular, it is preferable to use extrusion molding with a T-die, since a sheet-shaped molded body having a uniform thickness can be continuously produced.

In terms of the processability, the thermoplastic polyurethane having a carboxylic acid ester group has a high temperature-side melting point, which is a melting point of the crystal of hard segments, of preferably 50 to 100°C, and more preferably 60 to 90°C.

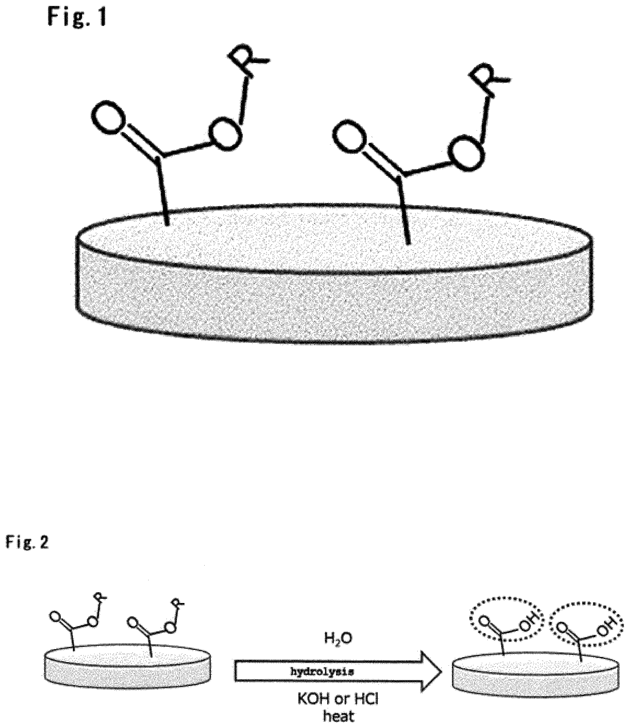

The polyurethane produced in the above-described manner has a carboxylic acid ester group. The schematic structural diagram of such a polyurethane is shown in FIG. 1.

The content ratio of the carboxylic acid ester group in the polyurethane is not particularly limited, but is preferably 1 to 20 mass%, and more preferably 3 to 10 mass% in terms of the carboxylic acid, since a significant effect in modifying the polyurethane surface is easily achieved.

The polyurethane may optionally contain additives such as a cross-linking agent, a filler, a cross-linking accelerator, a cross-linking auxiliary, a softening agent, a tackifier, an aging inhibitor, a foaming agent, a processing auxiliary, an adhesion-imparting agent, an inorganic filler, an organic filler, a crystal nucleating agent, a heat stabilizer, a weathering stabilizer, an antistatic agent, a colorant, a lubricant, a flame retardant, a flame retardant auxiliary (e.g., antimony oxide), a blooming inhibitor, a release agent, a thickener, an antioxidant, and a conductive agent. The content ratio of the additives is not particularly limited, but is preferably 50 mass% or less, more preferably 20 mass% or less, and particularly preferably 5 mass% or less.

The polyurethane according to the present embodiment is preferably a thermoplastic polyurethane. Note that thermoplasticity means that the properties of being moldable by a molding method that undergoes heating and melting steps, such as extrusion molding, injection molding, calendering, and 3D-printer molding. The molded body for use in a polishing pad that can be used as a polishing layer of a polishing pad can be obtained by molding a polyurethane by any of the above-described various molding methods. In particular, it is preferable that extrusion molding using a T-die is used, since a sheet-shaped molded body that is excellent in productivity and uniform in thickness can be easily obtained.

The molded body for use in a polishing pad may be either a foamed molded body or an unfoamed molded body. In particular, it is preferable that the molded body is an unfoamed molded body, since the polishing characteristics are less likely to vary, thus making it possible to achieve stable polishing. For example, in the case of a polishing layer using a foamed polyurethane produced by forming and curing by casting, the polishing characteristics such as the planarization performance and the planarization efficiency are likely to vary due to variations of the foam structure, and increasing the hardness for enhancing the planarization performance tends to be difficult.

The surface properties of such a molded body of a polyurethane having a carboxylic acid ester group can be modified simply by hydrolyzing the carboxylic acid ester group after molding. Specifically, it is possible to produce a carboxyl group on the surface of the polyurethane molded body by hydrolyzing the carboxylic acid ester group present in at least one of a side chain, a main chain terminal, and a main chain skeleton of the polyurethane. It is also possible to further convert the carboxylic acid retained by the polyurethane into another functional group. By selecting the conditions for hydrolyzing the carboxylic acid ester group, it is also possible to adjust the amount of the carboxylic acid to be produced. As a result, it is possible to adjust the modification of the surface properties such as the zeta potential and the hydrophilicity of the surface after molding the polyurethane molded body. Next, the hydrolysis, which is a modification treatment, of the carboxylic acid ester group included in the polyurethane, will be described in detail.

By hydrolyzing a carboxylic acid ester group present in a polyurethane, it is possible to produce a carboxyl group on the surface of the polyurethane. Specifically, for example, as shown in FIG. 2, by hydrolyzing a carboxylic acid ester group of a molded body of a polyurethane having the carboxylic acid ester group, it is possible to convert the carboxylic acid ester group into a carboxyl group.

The hydrolysis reaction is performed through treatment with a water-containing liquid. As the water-containing liquid, it is preferable to use, for example, an aqueous acid solution such as hydrochloric acid, or a basic solution such as an aqueous sodium hydroxide solution, an aqueous potassium hydroxide solution, and ammonia water, since the hydrolysis can be promoted by catalysis. Among these, in terms of the reactivity of hydrolysis, it is particularly preferable to use an aqueous sodium hydroxide solution or an aqueous potassium hydroxide solution. The temperature of the water-containing liquid for hydrolysis is not particularly limited, but is preferably 20 to 90°C, and more preferably 30 to 80°C, since the hydrolysis reaction can be easily controlled. Furthermore, the time for treatment with the water-containing liquid is not also particularly limited, but is preferably about 5 to 1440 minutes, and more preferably about 60 to 720 minutes, since the hydrolysis can be easily controlled.

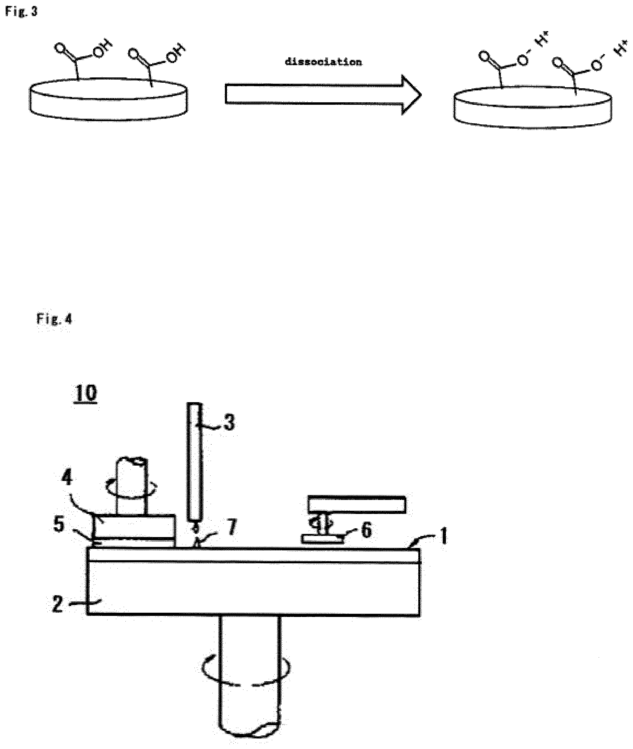

A polyurethane that has been modified by hydrolyzing a carboxylic acid ester group in this manner has a carboxyl group. As shown in FIG. 3, when the carboxyl group provided to the polyester comes into contact with an aqueous solution including an acidic region and having a pH that causes ionization of the carboxyl group, the carboxyl group dissociates into COO⁻ and H⁺. Then, the -COO⁻ in the surface imparts a negative potential to the surface of the polyurethane. In an application as a polishing layer of a polishing pad, which will be described below, such a negative potential reduces the zeta potential in the acidic region, and increases the affinity for the abrasive grains contained in an acidic slurry. In addition, the carboxyl group of the polyurethane increases the hydrophilicity of the surface of the polyurethane, thus enhancing the wettability thereof. Such a polyurethane can be preferably used in various applications of polyurethanes for which modification in hydrophilicity, electrical properties, and the like are required. Particularly, the polyurethane can be preferably use as a molded body for use in a polishing pad that can be used as a polishing layer of a polishing pad. In particular, a polishing layer using a polyurethane molded body having a carboxyl group reduces the surface potential of the polishing layer, thus enhancing the affinity for abrasive grains.

Next, a description will be given of a polishing pad including, as a polishing layer, a molded body of a polyurethane having a carboxylic acid ester group. The polishing pad according to the present embodiment includes a polishing layer obtained by cutting out a piece such as a circular piece from a sheet-shaped molded body of a polyurethane having a carboxylic acid ester group.

For example, as the slurry used for CMP, an acidic slurry and an alkaline slurry are available. The acidic slurry and the alkaline slurry may be selectively used according to the purpose of polishing, or may be used in combination in the case of performing a multi-step polishing process. The abrasive grains contained in the alkaline slurry usually have a negative zeta potential. In the case of using a polishing layer whose zeta potential is negative when an alkaline slurry is used, the zeta potential of the polishing layer can be kept negative, which makes polishing debris less likely to adhere to the polishing layer, thus reducing the occurrence of scratches and defects. However, in the case of a polishing layer whose zeta potential is negative in an alkaline condition, the zeta potential of the polishing layer is often positive when an acidic slurry is used.

The abrasive grains contained in an acidic slurry often have a positive zeta potential. On the other hand, for example, the zeta potential of the surface of a silicon wafer is usually negative in an acidic condition. In this case, it seems that the negative electric charge on the surface of the silicon wafer and the positive electric charge of the abrasive grains contained in the acidic slurry attract each other, thus resulting in high mutual affinity. On the other hand, the zeta potential of a commonly used polyurethane tends to be positive in an acidic region, in particular, a pH region lower than a pH of 3, reach the isoelectric point near a pH of 3 to approach 0, and to be negative in an alkaline region having a high pH.

It seems that when a base material whose zeta potential is negative in an acidic region is polished with a polishing layer of a polyurethane whose zeta potential is positive in the acidic region, using abrasive grains whose zeta potential is positive in an acidic slurry, the polishing layer having a positive zeta potential and the abrasive grains having a positive zeta potential repel each other, resulting in poor affinity. Therefore, it seems that when a base material whose zeta potential is negative in an acidic region is polished with an acidic slurry, it is preferable to use a polishing layer whose zeta potential is more negative in the acidic region. The present inventors have achieved means for improving the polishing rate by interposing abrasive grains exhibiting a positive zeta potential between a base material exhibiting a negative zeta potential and a polishing layer exhibiting a negative zeta potential, thus stabilizing the abrasive grains between the base material and the polishing layer.

A molded body used as a material of the polishing layer of the present embodiment is a molded body of a polyurethane having a carboxyl group. A polishing layer using a molded body of a polyurethane having a carboxyl group on the surface thereof can achieve a polishing surface whose zeta potential at a pH of 3.0 is -1.0 mV or less as a result of the carboxyl group in the polishing surface dissociating into - COO⁻ when coming into contact with an acidic slurry. When the zeta potential at a pH of 3.0 is -1.0 mV or less, the polishing layer exhibits high affinity for the abrasive grains exhibiting a positive zeta potential in an acidic region. Then, the abrasive grains exhibiting a positive zeta potential are interposed between the base material exhibiting a negative zeta potential in the acidic region and the polishing layer exhibiting a negative zeta potential, so that the abrasive grains exhibit high affinity for both the base material and the polishing layer, thus making it possible to achieve a high polishing rate.

The zeta potential at a pH of 3.0 to 8.0 of the polyurethane that forms the polishing layer is preferably -1.0 mV or less, more preferably -2.0 mV to -40 mV, particularly preferably -3.0 to -30 mV, and quite particularly preferably - 5.0 to -20 mV. In particular, when the zeta potential at a pH of 3.0 of the polishing pad exceeds -1.0, the polishing slurry and the polishing pad are likely to electrically repel each other, thus resulting in a low affinity. Here, a zeta potential is a potential that is generated on the surface (slip plane) of an electric double layer by counter ion according to the surface electric charge of a substance when the substance comes into contact with a liquid. In the present embodiment, the zeta potential is a zeta potential measured with an electrophoretic light scattering device (ELS-Z, manufactured by Otsuka Electronics Co., Ltd.), using a monitor latex (manufactured by Otsuka Electronics Co., Ltd.) dispersed in 10 mM aqueous NaCl solution that had been adjusted to a pH of 3.0 with an aqueous HCl solution.

The zeta potential at a pH of 4.0 of the polyurethane that forms the polishing layer is preferably -1.0 mV or less, more preferably -5.5 to -40 mV, particularly preferably -7.5 to -30 mV, and quite particularly preferably - 10.0 to -30 mV, since a polishing layer having a zeta potential at a pH of 3.0 of -1.0 mV or less is easily obtained.

The polyurethane that forms the polishing layer has a storage modulus at 50°C after swollen to saturation with water at 50°C, of preferably 50 to 1200 MPa, more preferably 100 to 1100 MPa, and particularly preferably 200 to 1000 MPa. When the storage modulus at 50°C after swollen to saturation with water at 50° of the polyurethane is too low, the polishing layer becomes too soft, so that the polishing rate is reduced. When it is too high, increased scratches tend to occur on the surface to be polished of the object to be polished.

The content of the nitrogen atoms derived from the isocyanate group of the polyurethane that forms the polishing layer is preferably 4.5 to 7.6 mass%, more preferably 5.0 to 7.4 mass%, and particularly preferably 5.2 to 7.3 mass%, since a polyurethane having a storage modulus at 50°C after swollen to saturation with water at 50°C, of 50 to 1200 MPa is easily obtained.

The contact angle with water of the polyurethane that forms the polishing layer is preferably 80 degrees or less, more preferably 78 degrees or less, particularly preferably 76 degrees or less, and quite particularly preferably 74 degrees or less. When the contact angle with water of the polyurethane is too large, the hydrophilicity on the polishing surface of the polishing layer is reduced, so that increased scratches tend to occur.

The polishing layer is finished by adjusting the dimensions, shape, thickness and the like of a molded body for use in a polishing pad through cutting, slicing, punching, and the like. The thickness of the polishing layer is not particularly limited, but is preferably 0.3 to 5 mm, more preferably 1.7 to 2.8 mm, and particularly preferably 2.0 to 2.5 mm, because of the ease of production and handling, and the stability of the polishing performance.

The hardness of the polishing layer is preferably 60 or more, and more preferably 65 or more, as a JIS-D hardness. When the JIS-D hardness is too low, the ability of the polishing pad to follow the surface to be polished tends to increase, resulting in a reduction in the local flatness.

Preferably, recesses, which are grooves or holes, are formed in a predetermined concentric pattern in the polishing surface of the polishing layer by grinding or laser processing. Such recesses are useful for uniformly and sufficiently supplying a slurry to the polishing surface, as well as discharging polishing debris that could cause scratches, and preventing a damage to the wafer caused by adsorption by the polishing layer. For example, in the case of forming grooves concentrically, the interval between the grooves is preferably about 1.0 to 50 mm, more preferably about 1.5 to 30 mm, and particularly preferably about 2.0 to 15 mm. The width of the grooves is preferably about 0.1 to 3.0 mm, and more preferably about 0.2 to 2.0 mm. The depth of the grooves is preferably about 0.2 to 1.8 mm, and more preferably about 0.4 to 1.5 mm. The cross-sectional shape of the grooves may be appropriately selected from, for example, a rectangular shape, a trapezoidal shape, a triangular shape, and a semicircular shape, according to the purpose.

In the case of a thermoplastic polyurethane in the form of an unfoamed molded body, the density of the unfoamed molded body is preferably 1.0 g/cm³ or more, more preferably 1.1 g/cm³ or more, and particularly preferably 1.2 g/cm³ or more. When the density of the unfoamed molded body is too low, the polishing layer tends to become too soft, resulting in a reduction in the local flatness.

The polishing pad may be a monolayer polishing pad formed only by a polishing layer made of the above-described polyurethane molded body, or may be a multilayer polishing pad in which a cushioning layer is stacked on the surface of the polishing layer that is not the polishing surface. It is preferable that the cushioning layer is a layer having a hardness lower than the hardness of the polishing layer. When the hardness of the cushioning layer is lower than the hardness of the polishing layer, the hard polishing layer follows the local irregularities of the surface to be polished, and the cushioning layer follows the warpage and the undulations of the entire base material to be polished, so that it is possible to achieve polishing that is well-balanced in the global flatness and the local flatness.

Specific examples of materials that can be used as the cushioning layer include composites obtained by impregnating a non-woven fabric with a polyurethane (e.g., "Suba 400" manufactured by (Nitta Haas Incorporated)); rubbers such as a natural rubber, a nitrile rubber, a polybutadiene rubber, and a silicone rubber; thermoplastic elastomers such as a polyester-based thermoplastic elastomer, a polyamide-based thermoplastic elastomer, and a fluorine-based thermoplastic elastomer; foamed plastics; and polyurethanes. Among these, a polyurethane having a foam structure is particularly preferable in the flexibility desirable for the cushioning layer is easily achieved.

The thickness of the cushioning layer is not particularly limited, but is preferably 0.5 to 5 mm, for example. When the cushioning layer is too thin, the effect of following the warpage and the undulations of the entire material to be polished tends to be reduced, resulting in a reduction in the global flatness. On the other hand, when the cushioning layer is too thick, the polishing pad as a whole tends to become soft, making it difficult for polishing to be performed in a stable manner. In the case of stacking the cushioning layer on the polishing layer, the thickness of the polishing pad is preferably about 0.3 to 5 mm.

Next, one embodiment of CMP using the polishing pad as described above will be described.

In the CMP, a CMP apparatus 10 including a rotary platen 2 having a circular shape as viewed in a top view, a slurry supply nozzle 3, a carrier 4, and a pad conditioner 6 as shown in FIG. 4 is used, for example. A polishing pad 1 including the above-described polishing layer is attached to the surface of the rotary platen 2 using double-sided tape or the like. In addition, the carrier 4 supports an object 5 to be polished.

In the CMP apparatus 10, the rotary platen 2 is rotated by a motor (not shown) in the direction indicated by the arrow. The carrier 4 is rotated, in the plane of the rotary platen 2, by a motor (not shown), for example, in the direction indicated by the arrow. The pad conditioner 6 is also rotated, in the plane of the rotary platen 2, by a motor (not shown), for example, in the direction indicated by the arrow.

First, while pouring distilled water onto the polishing surface of the polishing pad 1 that is fixed to the rotary platen 2 and is rotated, the CMP pad conditioner 6 in which diamond particles are fixed onto the surface of a carrier by electrodeposition of nickel or the like is pressed against the polishing surface so as to condition the polishing surface of the polishing pad 1. Through conditioning, the polishing surface is adjusted to have a surface roughness suitable for polishing the surface to be polished. Next, a slurry 7 is supplied from the slurry supply nozzle 3 to the polishing surface of the rotating polishing pad 1. In performing CMP, a lubricating oil, a coolant, and the like may be optionally used in combination with the slurry.

Here, as the slurry, it is preferable to use a slurry for use in CMP that contains, for example, a liquid medium such as water or oil; abrasive grains such as silica, alumina, cerium oxide, zirconium oxide or silicon carbide; a base, an acid, a surfactant, an oxidizing agent such as a hydrogen peroxide solution, a reducing agent, and a chelating agent. Note that an acidic slurry, an alkaline slurry, and a near neutral slurry are available as the slurry; however, in the case of using the polishing layer formed by the polyurethane molded body described above, it is particularly preferable to use an acidic slurry having a pH of 2.0 to 7.0, in particular, a pH of 3.0 to 6.0, since the high affinity for the slurry can be maintained when performing CMP.

Then, the object 5 to be polished that is fixed to the carrier 4 and is rotated is pressed against the polishing pad 1 on which the slurry 7 is evenly spread on the polishing surface of the polishing layer. Then, the polishing treatment is continued until a predetermined flatness is achieved. Adjustment of the pressing force applied during polishing or the speed of relative movement between the rotary platen 2 and the carrier 4 affects the finishing quality.

The polishing conditions are not particularly limited; however, the rotational speed of each of the rotary platen and the carrier is preferably as low as 300 rpm or less in order to efficiently perform polishing, and the pressure applied to the object to be polished is preferably 150 kPa or less in order to prevent a flaw from being caused after polishing. During polishing, it is preferable that the slurry is continuously supplied to the polishing surface using a pump or the like. The amount of the slurry supplied is not particularly limited, but the polishing slurry is preferably supplied such that the polishing surface is constantly covered with the slurry.

Then, after the object to be polished that has undergone polishing is fully washed with running water, it is preferable to dry the object to be polished by removing water droplets attached thereto by using a spin drier or the like. In this manner, a smooth surface can be achieved over the entire surface to be polished as a result of polishing the surface to be polished with the slurry.

Such CMP can be preferably used for polishing performed during the production process of various semiconductor devices, microelectro mechanical systems (MEMS), and the like. The CMP can be preferably used for polishing objects to be polished, including, for example, an insulating film such as an oxide film formed on a semiconductor substrate, a wiring metal film of copper, aluminum, tungsten or the like; and a barrier metal film of tantalum, titanium, tantalum nitride, titanium nitride or the like, in particular, an insulating film such as an oxide film. The CPM can also be used for polishing a metal film on which a pattern such as a wiring pattern or a dummy pattern is formed. The pitch between lines in the pattern may vary from one product to another, but is usually about 50 nm to 100 µm.

### [Examples]

An example of each of the polyurethane, the polishing pad, and the modification method thereof according to the present invention will be described by way of examples. It should be noted that the scope of the present invention is not to be construed as being limited to the following examples.

### [Example 1]

A polytetramethylene glycol (PTMG 850) having a number-average molecular weight of 850, diethyl tartrate (DET), 1,4-butanediol (1,4-BD), and 4,4'-diphenylmethane diisocyanate (MDI) were mixed at a mass ratio of PTMG 850:DET:1,4-BD:MDI = 17.9:8.70:15.2:58.1, to prepare a raw material blend. Here, DET/1,4-BD = 20/80 (molar ratio). Then, the raw material blend was continuously supplied to a coaxially rotating twin-screw extruder using a metering pump to perform continuous melt-polymerization, and the melt was cooled by being continuously extruded into water from the die of the twin-screw extruder, thereby forming a strand. The strand was finely cut into pellets using a pelletizer, and the pellets were dried through dehumidification at 80°C for 20 hours, thus producing pellets of a thermoplastic polyurethane (PU1) having a carboxylic acid ester group in a side chain.

Then, the properties of the thermoplastic polyurethane (PU1) were evaluated as follows.

### (Modification of Thermoplastic Polyurethane, Measurement of Zeta Potential Before and After Modification)

5 to 14 g of the pellets of PU1 were sandwiched between Teflon (registered trademark) sheets, and were molded by being hot pressed at 200 to 230°C, using a hot pressing machine. In this manner, an unfoamed molded body of PU1 having a thickness of 0.3 to 0.5 mm was obtained. Then, modification treatment for hydrolyzing the carboxylic acid ester group of the unfoamed molded body of PU1 was performed, to convert the carboxylic acid ester group into a carboxyl group. The modification treatment was performed under each of the following three conditions: (i) immersion in an aqueous solution (0.1 M) of potassium hydroxide (KOH) at 50°C for 24 hours, (ii) immersion in an aqueous solution (0.1 M) of hydrochloric acid (HCl) at 50°C for 24 hours, and (iii) immersion in pure water at 50°C for 24 hours. In this manner, unfoamed molded bodies of a thermoplastic polyurethane having a carboxyl group on the surface thereof were obtained.

Then, the unfoamed molded bodies of a thermoplastic polyurethane before and after the modification treatment were each cut out into 30 mm × 60 mm, and the surfaces thereof were washed, to form test pieces. Then, the zeta potentials at a pH of 3.0, a pH of 4.0, and a pH of 7.0 of each of the test pieces were measured using an electrophoretic light scattering device (ELS-Z, manufactured by Otsuka Electronics Co., Ltd.). Specifically, each sample was attached to a plate measurement cell of the electrophoretic light scattering device, and measurement was carried out using a monitor latex (manufactured by Otsuka Electronics Co., Ltd.) dispersed in 10 mM aqueous sodium chloride solution that had been adjusted to a pH of 3.0 and a pH of 4.0 with an aqueous hydrochloric acid solution. Similarly, measurement was also carried out using a monitor latex dispersed in 10 mM aqueous sodium chloride solution that had been adjusted to a pH of 7.0 with an aqueous sodium hydroxide solution.

### (Contact Angle with Water)

Using a hot pressing machine, films of PU1 having a thickness of 300 µm were produced. Then, the films of PU1 were subjected to modification treatment under the same conditions as those for the above-described modification treatment. Then, the films before and after the modification treatment were each allowed to stand for 3 days under the conditions: 20°C and 65% RH. Then, the contact angle with water of each of the films before and after the modification treatment was measured using a DropMaster 500 manufactured by Kyowa Interface Science Co., Ltd.

The results of the above-described measurements are shown in Table 1 below.

**[Table 1]**

| Example No. | 1 | | | 2 | | | 3 | | | 4 | | | 5 | | | Com. Ex. 1 | | |
|---|---|---|---|---|---|---|---|---|---|---|---|---|---|---|---|---|---|---|
| Type of polyurethane | PU1 | | | PU2 | | | PU3 | | | PU4 | | | PU5 | | | PU6 | | |
| Blending ratio (mass%) | | | | | | | | | | | | | | | | | | |
| DET | 8.7 | | | 18.0 | | | 9.4 | | | - | | | - | | | - | | |
| BCP | - | | | - | | | - | | | 7.9 | | | - | | | - | | |
| MDB | - | | | - | | | - | | | - | | | 7.0 | | | - | | |
| 1,4-BD | 15.2 | | | 11.8 | | | 16.4 | | | 15.1 | | | 15.1 | | | 18.4 | | |
| PTMG 850 | 17.9 | | | 12.1 | | | 13.4 | | | 19.0 | | | 19.7 | | | 23.5 | | |
| MDI | 58.1 | | | 58.1 | | | 60.8 | | | 58.1 | | | 58.1 | | | 58.1 | | |
| Mol% in chain extender (a) of chain extender (a1) having carboxylic acid ester group | 20 | | | 40 | | | 20 | | | 20 | | | 20 | | | 0 | | |
| Zeta potential (before modification) | | | | | | | | | | | | | | | | | | |
| pH.3.0 | -0.7 | | | -2.1 | | | -0.9 | | | -0.9 | | | 0.9 | | | 0.6 | | |
| pH.5.0 | -1.6 | | | -2.6 | | | -1.8 | | | -1.0 | | | -0.1 | | | -5.0 | | |
| pH.8.0 | -5.4 | | | -6.2 | | | -6.5 | | | -14.1 | | | -19.0 | | | -13.5 | | |
| Contact angle (degrees) (before modification) | 73 | 73 | 73 | 76 | 76 | 76 | 74 | 74 | 74 | 74 | 74 | 74 | 75 | 75 | 75 | 70 | 70 | 70 |
| Reaction solution | KOH | HCl | H₂O | KOH | HCl | H₂O | KOH | HCl | H₂O | KOH | HCl | H₂O | KOH | HCl | H₂O | KOH | HCl | H₂O |
| Zeta potential (after modification) | | | | | | | | | | | | | | | | | | |
| pH.3.0 | -10.7 | -3.6 | -3.8 | -20.6 | -6.5 | -6.2 | -11.3 | -4.0 | -4.1 | -3.0 | -3.2 | **-2.1** | -3.7 | -2.8 | -3.0 | 0.6 | 0.5 | 0.6 |
| pH.5.0 | -13.5 | -5.5 | -5.3 | -23.3 | -8.0 | -7.3 | -15.1 | -6.7 | -6.8 | -5.2 | -5.5 | -4.2 | -5.5 | -3.2 | -3.0 | -7.0 | -6.5 | -5.5 |
| pH.8.0 | -18.6 | -14.1 | -13.7 | -25.8 | -17.2 | -15.6 | -20.2 | -16.4 | -15.2 | -16.0 | -15.3 | -15.0 | -28.0 | -23.0 | -25.0 | -14.0 | -13.0 | -13.7 |
| Contact angle (degrees) (after modification) | 59 | 68 | 62 | 50 | 69 | 68 | 60 | 68 | 67 | 64 | 66 | 65 | 67 | 69 | 68 | 70 | 70 | 70 |

### [Example 2]

Pellets of a thermoplastic polyurethane (PU2) having a carboxylic acid ester group in a side chain were produced in the same manner as in Example 1 except that the raw material blend was changed to a raw material blended at a ratio of PTMG 850:DET:1,4-BD:MDI = 12.1:18.0:11.8:58.1. Here, DET/1,4-BD = 40/60 (molar ratio). Then, the properties of the thermoplastic polyurethane were evaluated in the same manner as in Example 1 except that the pellets of PU2 were used in place of the pellets of PU1. The results are shown in Table 1.

### [Example 3]

Pellets of a thermoplastic polyurethane (PU3) having a carboxylic acid ester group in a side chain were produced in the same manner as in Example 1 except that the raw material blend was changed to a raw material blend blended at a ratio of PTMG 850:DET:1,4-BD:MDI = 13.4:9.4:16.4:60.8. Here, DET/1,4-BD = 20/80 (molar ratio). Then, the properties of the thermoplastic polyurethane were evaluated in the same manner as in Example 1 except that the pellets of PU3 were used in place of the pellets of PU1. The results are shown in Table 1.

### [Example 4]

Pellets of a thermoplastic polyurethane (PU4) having a carboxylic acid ester group in a terminal were produced in the same manner as in Example 1 except that the raw material blend was changed to a raw material blend in which PTMG 850, 1-(tert-butoxycarbonyl)-3-pyrrolidinol (BCP), 1,4-BD, and MDI were blended at a ratio of PTMG 850:BCP:1,4-BD:MDI = 19.0:7.90:15.1:58.1. Here, BCP/1,4-BD = 20/80 (molar ratio). Then, the properties of the thermoplastic polyurethane were evaluated in the same manner as in Example 1 except that the pellets of PU4 were used in place of the pellets of PU1. The results are shown in Table 1.

### [Example 5]

Pellets of a thermoplastic polyurethane (PU5) having a carboxylic acid ester group in a side chain were produced in the same manner as in Example 1 except that the raw material blend was changed to a raw material blend in which PTMG 850, methyl 2,4-dihydroxybenzoate (MDB), 1,4-BD, and MDI were blended at a ratio of PTMG 850:MDB:1,4-BD:MDI = 19.7:7.0:15.1:58.1. Here, MDB/1,4-BD = 20/80 (molar ratio). Then, the properties of the thermoplastic polyurethane were evaluated in the same manner as in Example 1 except that the pellets of PU5 were used in place of the pellets of PU1. The results are shown in Table 1.

### [Comparative Example 1]

Pellets of a thermoplastic polyurethane (PU6) were produced in the same manner as in Example 1 except that the raw material blend was changed to a raw material blend blended at a ratio of PTMG 850:1,4-BD:MDI = 23.5:18.4:58.1. Note that PU6 does not have a carboxylic acid ester group in a side chain. Then, the properties of the thermoplastic polyurethane were evaluated in the same manner as in Example 1 except that the pellets of PU6 were used in place of the pellets of PU1. The results are shown in Table 1.

Referring to Table 1, it can be seen that the zeta potentials of the polyurethanes of Examples 1 to 5, which have a carboxylic acid ester group in at least one of a side chain and a main chain terminal, were more significantly lowered by the modification treatment than the zeta potential of the polyurethane of Comparative Example 1, which has no carboxylic acid ester group. It can be also seen that the contact angles thereof were also decreased accordingly.

## Claims

1. A polyurethane for use in a polishing layer, comprising
a carboxylic acid ester group.

2. The polyurethane for use in a polishing layer according to claim 1,
wherein the polyurethane has the carboxylic acid ester group in at least one of a side chain, a main chain terminal, and a main chain skeleton.

3. The polyurethane for use in a polishing layer according to claim 1 or 2, comprising
a monomer unit having a carboxylic acid ester group.

4. The polyurethane for use in a polishing layer according to claim 3,
wherein the polyurethan comprises, as the monomer unit, at least a chain extender unit (a), a polymer polyol unit (b), and an organic diisocyanate unit (c), and at least one of the chain extender unit (a) and the polymer polyol unit (b) has the carboxylic acid ester group.

5. The polyurethane for use in a polishing layer according to claim 4,
wherein the chain extender unit (a) includes a monomer unit derived from at least one compound selected from the group consisting of a tartaric acid diester, 1-(tert-butoxycarbonyl)-3-pyrrolidinol, and methyl 2,4-dihydroxybenzoate.

6. The polyurethane for use in a polishing layer according to any one of claims 1 to 5,
wherein the polyurethane is a thermoplastic polyurethane.

7. A polishing layer comprising
the polyurethane for use in a polishing layer according to any one of claims 1 to 6.

8. The polishing layer according to claim 7,
wherein the polishing layer is an unfoamed molded body of the polyurethane for use in a polishing layer.

9. A method for modifying a polishing layer, comprising the steps of:
preparing a polishing layer including a polyurethane having a carboxylic acid ester group; and
hydrolyzing the carboxylic acid ester group of the polyurethane, to produce a carboxyl group.

10. A polishing layer comprising a molded body of a thermoplastic polyurethane having a carboxyl group,
wherein the polishing layer has a zeta potential at a pH of 3.0 to 8.0, of -1.0 mV or less.

11. The polishing layer according to claim 10,
wherein the polishing layer has a contact angle with water of 80 degrees or less.

12. A polishing pad comprising
the polishing layer according to any one of claims 7 to 11.
